Europäisches Patentamt

European Patent Office

Office européen des brevets

(11) Publication number: **0 098 111**
**B1**

(12) **EUROPEAN PATENT SPECIFICATION**

(45) Date of publication of patent specification: **09.08.89**

(21) Application number: **83303637.9**

(22) Date of filing: **23.06.83**

(51) Int. Cl.⁴: **H 01 L 21/28,** H 01 L 29/60, H 01 L 29/78

(54) **Vertical IGFET device and method for fabricating same.**

(30) Priority: **24.06.82 GB 8218286**
**28.04.83 US 489307**
**02.06.83 US 500399**
**10.06.83 US 503044**

(43) Date of publication of application:
**11.01.84 Bulletin 84/02**

(45) Publication of the grant of the patent:
**09.08.89 Bulletin 89/32**

(84) Designated Contracting States:
**DE FR GB IT SE**

(56) References cited:
**EP-A-0 022 388**
**JP-A-53 075 877**
**US-A-4 101 350**

**PATENTS ABSTRACTS OF JAPAN, vol. 6, no. 160 (E-126)1038r, 21st August 1982; & JP - A - 57 79 660**

(73) Proprietor: **Harris Semiconductor Patents, Inc.**
**1025 West NASA Boulevard**
**Melbourne, Florida 32919 (US)**

(72) Inventor: **Jastrzebski, Lubomir Leon**
**41 Tennyson Drive**
**Plainsboro New Jersey (US)**
Inventor: **Kokkas, Achilles George**
**12-16 Deer Creek Drive**
**Plainsboro New Jersey (US)**
Inventor: **Ipri, Alfred Charles**
**7 Cotswold Lane**
**Princeton New Jersey (US)**

(74) Representative: **Smith, Thomas Ian Macdonald et al**
**RCA International Limited Burdett House 15-16 Buckingham Street**
**London WC2N 6DU (GB)**

Courier Press, Leamington Spa, England.

# Description

The present invention relates to vertical insulated gate field effect transistors (IGFETs) which can be used in integrated circuit applications. Additionally, it relates to a method for fabricating such devices in a relatively simple manner.

A vertical IGFET, as defined herein, refers to a device wherein the transistor current flow is regulated along a direction which is perpendicular to the major surfaces of the substrate on which the device is disposed. Source, body and drain regions of the transistor are in an overlying relationship to one another, and an insulated gate electrode is contiguous with at least a portion of the body region. When the insulated gate is appropriately electrically biased, an inversion channel is formed between the source and drain regions in that portion of the body region adjacent thereto.

The vertical configuration of the source, body and drain regions in such a vertical IGFET intrinsically consumes less surface area of the substrate than does a lateral configuration. Thus, if the source, body and drain regions can be made suitably small, the resulting structure might be used advantageously in integrated circuits, where device packing density is an important consideration.

Such vertical IGFETs can be fabricated utilizing the epitaxial lateral overgrowth (ELO) fabrication technique. Basically, the ELO process involves a repetitious, two-phase, deposition/etch cycle whereby monocrystalline silicon is grown from a monocrystalline silicon surface which is exposed within the aperture of an overlying mask. In manufacturing a conventional vertical IGFET, photolithographic limitations constrain the spacing, i.e. the packing density between neighboring gates.

JP—A—53-75877 (Application No. 51-152306) discloses a vertical MOS transistor formed on a semiconductor substrate. In the method of this document, a six layer structure is laid down on the surface of the substrate, there being three insulating layers alternating with three conducting layers, the layer adjacent the substrate being an insulating layer. A hole is formed through the layers to the substrate, and silicon is grown epitaxially from the substrate to fill the hole. The bottom portion of the epitaxilly grown silicon contacts the bottom-most conducting layer, and is the source region. A middle portion is adjacent but insulated from the middle conducting layer and is the channel region. A top portion contacts the top conducting layer and is the drain region.

A vertical IGFET device according to one aspect of the invention as set forth in the claims is formed on a substrate which includes a monocrystalline semiconductor portion at a surface thereof. An apertured insulated gate is disposed on the surface of the substrate such that an area of monocrystalline semiconductor material is exposed through the aperture. Within the aperture of the insulated gate an epitaxial semiconductor region extends from the surface of the substrate to a height substantially equal to that of the insulated gate. The epitaxial region has a portion which is the same conductivity type as the substrate and which overlies, within the aperture, another portion of another conductivity type. The invention also provides, as another aspect thereof, a method of fabrication such as IGFET as set forth in the method claims.

The present invention provides a method by which, using conventionally available processing techniques, the spacing between gates can be reduced by greater than an order of magnitude as compared with a conventional structure. The invention of this space-reducing method led to the realization of a device structure which is well suited to application in integrated circuits in that it can be constructed to incorporate a plurality of vertical IGFETs consuming a substrate area equal to that of a single vertical IGFET.

In the accompanying drawings:

Figures 1 through 4 are cross-sectional views of a processing sequence used to fabricate a vertical IGFET device of the present invention.

Figures 5 through 8 are cross-sectional views of a second embodiment of the processing sequence. The vertical IGFET device illustrated in Figure 8 is an alternative embodiment to that shown in Figure 4.

Figure 9 represents a silicon-on-insulator substrate structure on which a vertical IGFET device of the present invention can be fabricated.

Figure 10 is a cross-sectional view of a vertically integrated IGFET device incorporating four series-connected vertical IGFETs.

Figure 11 is a cross-sectional view taken along section line 11—11 of Figure 10.

Figure 12 is a schematic representation of the device of Figures 10 and 11.

Figure 13 is a cross-sectional view of a vertically integrated IGFET device incorporating four vertical IGFETs connected in parallel.

Figure 14 is a cross-sectional view taken along section 14—14 of Figure 13.

Figure 15 is a schematic representation of the device of Figures 13 and 14.

Figure 16 is a cross-sectional view of a vertically integrated CMOS inverter in accordance with the present invention.

Figure 17 is a schematic representation of the inverter of Figure 16.

Figure 18 is a cross-sectional view of a vertically integrated transmission gate.

Figure 19 is a schematic representation of the transmission gate of Figure 18.

Figure 20 is a cross-sectional view of a storage element, incorporating two cross-coupled inverters, in accordance with the present invention.

Figure 21 is a schematic representation of the basic storage element of Figure 20.

Figure 22 is an exemplary memory cell structure in accordance with the present invention. The memory cell incorporates two cross-coupled inverters which are accessed by a pair of access transistors.

Figure 23 is a schematic representation of the memory cell of Figure 22.

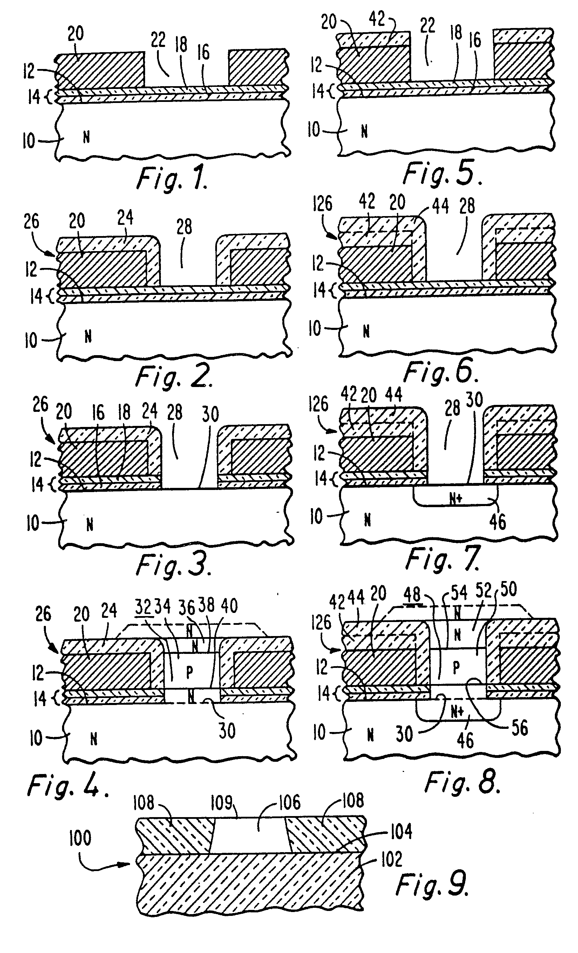

Figure 1 illustrates a substrate 10 having a major surface 12. In the preferred embodiment, the substrate 10 is a monocrystalline silicon wafer of a first conductivity type. It is not necessary that the entire substrate 10 comprise monocrystalline material. It is critical only that the portion of the surface 12 where the FET is to be formed comprises monocrystalline silicon.

A first insulating layer 14 is formed across the substrate surface 12. The first insulating layer 14 may comprise, for example, silicon nitride or silicon dioxide, and may be approximately 10 to 40 nm (100 to 400 Angstroms) thick. It can be conventionally formed, for example, by a chemical vapor deposition (CVD) process. In the preferred embodiment, as illustrated in Figure 1, the first insulating layer 14 comprises a lower layer 16 disposed on the surface 12, and an upper layer 18 disposed on the lower layer 16. The lower layer 16 comprises silicon dioxide, approximately 10 to 50 nm (100 to 500 Angstroms) thick, and the upper layer 18 comprises silicon nitride, approximately 10 to 50 nm (100 to 500 Angstroms) thick. The silicon dioxide lower layer 16 may be formed by thermal oxidation, and the silicon nitride upper layer 18 may be formed by CVD.

This two layer arrangement is preferable to a single, first insulating layer 14 of silicon nitride because deposition of silicon nitride directly on the surface of a silicon substrate can introduce crystalline defects in the substrate. By incorporating a silicon dioxide lower layer 16 between the silicon nitride upper layer 18 and the surface 12 of the silicon substrate 10, this source of defects is eliminated. This two-layer arrangement may also be preferable to a single, first insulating layer 14 of silicon dioxide because it may provide more flexibility in subsequent processing.

A layer of electrode material is then formed and defined on the surface of the first insulating layer 14 so as to form a gate electrode 20 having an aperture 22 therein. When the entire substrate surface 12 is not monocrystalline silicon, but rather includes a portion of monocrystalline silicon, the aperture 22 overlies a portion of the monocrystalline silicon portion. In the preferred embodiment, the electrode material is N+ doped polycrystalline silicon, and it is deposited and defined by a conventional sequence such as CVD, phosphorus doping, and photolithographic processing. The thickness of the electrode 20 will ultimately provide the channel length of the vertical FET, and thus it might be in the range of approximately 200 to 500 nm (2,000 to 50,000 Angstroms). The lateral dimensions of the aperture 22 will ultimately determine the number of vertical IGFETs which can be packed into a particular area of the major surface 12. Using conventional photolithographic pattern-generation techniques to form the electrode 20, an aperture 22 with dimensions in the 1 to 3 micron range is readily obtainable.

As illustrated in Figure 2, the electrode 22 is next coated with a second insulating layer 24. In the preferred embodiment, the second insulating layer 24 is silicon dioxide, and it is formed by thermally oxidizing the polycrystalline silicon electrode 20 to a thickness of approximately 10 to 100 nm (100 to 1,000 Angstroms). The apertured gate electrode 20 with the overlying second insulating layer 24 and underlying first insulating layer 14 is now referred to as an insulated gate 26. It should be noted that the aperture 22 in the gate electrode 20 of Figure 1 is now reduced in size by approximately the thickness of the second insulating layer 24, since the insulating layer 24 extends along the aperture walls of the gate electrode 20. The aperture in the insulated gate 26 is now referred to at 28.

As illustrated in Figure 3, that portion of the first insulating layer 14 exposed within the aperture 28 is now removed so as to expose a monocrystalline silicon area of the substrate surface 12 which will hereinafter be referred to as a nucleation site 30. Since, in the preferred embodiment, the material of the second insulating layer 24 is different from that of the upper layer 18, upper layer 18 can be selectively removed, with no further masking, by merely choosing an appropriate etchant. For example, the silicon nitride upper layer 18 (or a single, first layer 14 of silicon nitride) can be removed by immersion in hot phosphoric acid. This etchant will not attack the second insulating layer 24 of silicon dioxide or the underlying electrode 20. The silicon dioxide lower layer 16 can then be removed by immersion in an etchant such as buffered HF. Although this etchant will also remove some portion of the second insulating layer 24 of silicon dioxide, the relative thickness of the second layer 24 and the lower layer 16 is such that a continuous coating of a particular thickness of the second layer 24 remains following the removal of the lower layer 16. Thus, the described etching process provides a self-aligning technique for locating the nucleation site 30 within the insulated gate aperture 28. No additional photolithographic steps are required to perform this alignment.

It further should be recognized that the insulated gate electrode 26 can be fabricated in a self-aligned manner even if the first insulating layer 14 and second insulating layer 24 are of the same material. This can be achieved by appropriately selecting the relative thickness of the two layers such that a predetermined thickness of the second insulating layer 24 remains following the removal of the first insulating layer 14 from the nucleation site. Such a fabrication technique can be further enhanced by removing the first layer 14 with an anisotropic etching technique such as plasma or reactive-ion etching.

As illustrated in Figure 4, monocrystalline epitaxial silicon 32 is next grown from the nucleation site 30 so as to fill the aperture in the insulated gate 26. Optimally, the growth of the epitaxial silicon 32 is terminated when it is substantially coplanar with the second insulating layer 24 which overlies the gate electrode 20.

Alternatively, it can be terminated at some distance greater than the thickness of the insulated gate 26, such that the epitaxial silicon 32 overlies the second insulating layer 24, as shown by the broken line. The epitaxial silicon 32 can be formed by what is now referred to as the epitaxial lateral overgrowth (ELO) technique.

Basically, the ELO process involves a repetitious, two-phase, deposition/etch cycle whereby monocrystalline silicon is grown from a monocrystalline silicon surface which is exposed within the aperture of an overlying mask. When the silicon which is being epitaxially deposited grows through the aperture to a thickness greater than that of the mask, the epitaxial growth proceeds laterally, across the surface of the mask, as well as vertically. The deposition/etching cycle can be performed within a conventional reactor at atmospheric or reduced pressure. During the deposition phase of the cycle, the substrate is exposed to a gas mixture which comprises a silicon-source gas such as $SiH_2Cl_2$, a carrier gas such as hydrogen, and, optimally, a silicon-etching gas such as HCl. During the etching phase of the cycle, the substrate is exposed to a gaseous mixture comprising an etching gas such as HCl and a carrier gas such as hydrogen.

During the deposition phase, silicon deposits from the silicon-source gas onto exposed surfaces of the substrate 10 and second insulating layer 24. The silicon that deposits on the nucleation site 30 follows the monocrystalline lattice structure at that site, whereas the silicon which precipitates onto the second insulating layer 24 deposits in the form of isolated, non-single-crystalline aggregates. The gaseous composition and duration of the etching phase is designed so as to completely remove all the non-single-crystalline aggregates which are formed on the second insulating layer 24 following the deposition phase. Although this etching also removes some of the monocrystalline silicon growing from the nucleation site, the etch rate of the monocrystalline silicon is relatively low compared to the etch rate of the non-single-crystalline aggregates. Thus, after a single deposition/etching cycle, more silicon is deposited on the exposed silicon surfaces during the deposition phase than is etched during the etching phase, and all of the deposited material is monocrystalline in nature.

The epitaxial silicon 32 is doped so as to form a second-conductivity-type portion, hereinafter body region 34, having a thickness substantially equal to that of the gate electrode 20, and a first-conductivity-type portion, hereinafter source region 36, overlying the body region 34. The first-conductivity-type substrate 10 serves as a drain region in this structure, so as to form an FET with the source region 36 and body region 34.

A source/body PN junction 38 exists between the source region 36 and body region 34, and a body/drain PN junction 40 exists between the body region 34 and the substrate/drain region 10. Optimally, the body region 34 directly opposes the gate electrode 20. That is, the source/body junction 38 is substantially coplanar with the gate electrode 20/second insulating layer 24 interface where the second insulating layer 24 overlies the gate electrode 20, and the body/drain junction 40 is substantially coplanar with the interface between the gate electrode 20 and the first insulating layer 14.

It should be noted that the body/drain junction 40 is optimally not coplanar with the major substrate surface 12. Rather, it is displaced into the epitaxial region 32 by an approximate distance of from several hundred to several thousand Angstrons ($nm \times 10$). This displacement occurs during the ELO deposition and during subsequent processing, due to out-diffusion of first-conductivity-type modifiers from the nucleation site 30 and autodoping from the deposition-gas mixture. Both of these mechanisms are well understood in the semiconductor art, such that the precise location of the body/drain junction 40 can be manipulated by appropriately varying deposition parameters such as temperature, deposition gas pressure, and deposition rate.

Both the source and body regions 36 and 34 can be doped during the ELO deposition by introducing appropriate dopants to the deposition-gas mixture as the epitaxial silicon is grown. Alternatively, rather than doping the source region 36 during the ELO process, it can be doped subsequently by, for example, ion implantation and/or diffusion.

The described configuration serves to faciliate channel formation in that area of the body region 34 contiguous with the insulated gate 26 when the insulated gate is appropriately electrically biased. The configuration minimizes feedback capacitance due to overlap between the gate electrode 20 and the source region 36 and/or the drain region 10. When an appropriate voltage is applied to the gate electrode 20, an inversion channel is created in the body region 34 in that area of the body region adjacent to the insulated gate 26. This channel is used to regulate current flow between the source region 36 and the substrate/drain region 10 during IGFET operation. In the case of an NPN device, wherein the body region 34 is of P type conductivity, a positive gate voltage will create an N type channel. Similarly, a negative gate voltage can be used to form a P type channel of a PNP device, wherein the body region 34 is of N type conductivity.

It further should be understood that all references herein to source and drain regions can be reversed. The substrate can equivalently be considered the source region, and the top portion of the epitaxial silicon can be considered the drain region.

An alternative embodiment of the processing sequence described with reference to Figures 1 through 4 is illustrated in Figures 5 through 8. As shown in Figure 5, a first-conductivity-type substrate-drain region 10 having a major surface 12 is again provided. A first insulating layer 14 having a lower layer 16 and upper layer 18 is disposed on the major surface 12, and a gate electrode 20 having an aperture 22 therein is disposed on the first layer 14. Disposed on the top surface of the gate electrode 20, i.e., that surface which is substantially parallel to the major surface 12 of the substrate 10 and which doesn't include the electrode surface within the aperture 22, is a supplementary insulating layer 42. Preferably, the supplementary layer 42 is silicon dioxide, and it is approximately 100 to 500 nm (1000 to 5000 Angstroms) thick. It can be formed by thermal oxidation or CVD, and it can be defined during the photolithographic sequence which is used to define the aperture 22. Such a photolithographic sequence might, for example, include the steps of forming an oxide layer 42 on the polycrystalline silicon layer 20, forming a photoresist pattern on the oxide layer 42, etching the oxide layer 42, etching the polycrystalline silicon layer 20, and removing the photoresist.

As shown in Figure 6, a second insulating layer 44 next is formed over the electrode 20 and supplementary insulating layer 42. Again, the second insulating layer 44 coats the walls of the electrode 20 within the aperture 22, such that the aperture is now referred to at 28. In the alternative embodiment, the second insulating layer 44 is silicon dioxide, and it is formed by thermal oxidation so as to ensure growth on the walls of the aperture 22. The insulated gate, comprising the gate electrode 20, first insulating layer 14, supplementary insulating layer 42 and second insulating layer 44 is referred to at 126. It can be noted that, in the alternative embodiment when both the supplementary insulating layer 42 and the second insulating layer 44 are silicon dioxide, the thermal growth of the second insulating layer 42 likely will occur at the electrode 20/layer 42 interface, producing a structure wherein the supplementary layer 42 overlies the second insulating layer 44. Nonetheless, for clarity in the drawing, the second insulating layer 44 is shown overlying the supplementary insulating layer 42.

As illustrated in Figure 7, the first insulating layer 14 is next removed from the substrate surface 12 so as to expose a monocrystalline silicon nucleation site 30. The removal can be performed by a procedure similar to that described with reference to Figure 3. A high-conductivity drain region 46 is then is formed in the substrate/drain region 10, using the insulated gate 126 as a mask. The high-conductivity drain region 46 is of the first conductivity type, and it is of higher conductivity than the substrate/drain region 10. The high-conductivity drain region 46 can conveniently be formed by ion implantation of an appropriate dopant so as to yield a region which extends into the substrate from the surface 12 to a thickness of from approximately several hundred Angstroms to several thousand Angstroms (nm×10). Typically, following such an implantation, the dopant atoms are diffused so as to yield a region 46 which extends laterally beyond the periphery of the aperture 28.

As illustrated in Figure 8, monocrystalline epitaxial silicon 48 next is grown from the nucleation site 30 so as to fill the aperture 28 in the insulated gate 126. The epitaxial silicon may extend some distance vertically as well as laterally beyond the aperture 28, as shown by the broken line, and it can be grown by the previously described ELO technique. Again, that portion of the monocrystalline silicone 48 which opposes the gate electrode 20 is doped so as to form a body region 50 of the second conductivity type. That portion of the monocrystalline silicon 48 overlying the body region 50 is doped so as to form a source region 52 of the first conductivity type. A source/body PN junction 54 exists between the source and body regions 52 and 50, and a body/drain PN junction 56 exists between the body and high-conductivity drain regions 50 and 46. As with the embodiment illustrated in Figures 1 through 4, the doping of the epitaxial silicon 48 can be preformed either during or subsequent to the ELO growth.

The two major differences between the embodiment of Figures 1 through 4 and the embodiment of Figures 5 through 8 are the formation of a high-conductivity drain region 46, and the use of a supplementary insulating layer 42. It should be understood, however, that either of these process variations can readily be introduced into the sequence of Figures 1 through 4.

The use of a high-conductivity drain region 46 enhances the electrical performance of the device formed. It generally is desirable to structure an FET wherein the source and drain regions are of relatively high conductivity compared with the body region therebetween. The ion implantation of Figure 7 provides a means for increasing the conductivity of the substrate/drain region 10 relative to the body region 50. It should be recognized that although the relative conductivities between the source regions 52 and 36 and the body regions 50 and 34 have not been specified, the source regions 52 and 36 typically will have dopant concentrations equivalent to that of the high-conductivity drain region 46, and several orders of magnitude greater than those in the body regions 50 and 34.

As illustrated in the process sequence of Figures 5 through 8, the use of the supplementary insulating layer 42 creates a structure having a thicker source region 52. When the source region 52 laterally overlies the second insulating layer 44, the laterally overlying portion of the source region 52 is further separated from the gate electrode 20 than it is in the embodiment of Figure 4. This reduces source-to-gate feedback capacitance during device operation. Although the growth of the epitaxial silicon 48 optimally will be terminated when the epitaxial silicon is coplanar with the surface of the second insulating layer 44, practical manufacturing considerations might militate that some lateral overgrowth onto the second insulating layer 44 occurs.

Illustrated in Figure 9 is an alternative embodiment for the substrate 10 of the two previous processing sequences. The substrate, designated at 100, is conventionally referred to as a silicon-on-insulator or silicon-on-sapphire (SOS) structure. In this embodiment, an insulating wafer 102, such as sapphire, having a major surface 104, is provided. Disposed on the surface 104 is a monocrystalline silicon island 106 which has a surface 109 and which is surrounded by silicon dioxide 108. The substrate 100 can be readily and conventionally fabricated by, for example, depositing a monocrystalline silicon layer across the surface 104 of the sapphire wafer 102, masking a portion of the monocrystalline silicon layer corresponding to the surface 109, oxidizing the unmasked silicon, and removing the mask from the surface 109. The substrate 100 can now be substituted for the substrate 10 in either of the previously described processing sequences. The surface 109 of the monocrystalline silicon island 106 substantially will correspond to the nucleation site 30 in each of these sequences.

When incorporated into an integrated circuit device, an IGFET of the present invention can comprise a variety of configurations. For example, a single gate electrode 20 having a plurality of apertures 22 initially might be disposed on the first insulating layer 14. Within each of the apertures 22, an individual FET then can be formed, such that each of the FETs have a common substrate/drain region 10. This sort of design might be suitable, for example, in a decoder, memory array, or binary logic configuration. Another exemplary integrated circuit configuration would comprise a plurality of insulated gate electrodes 26 on the surface of a substrate, with each insulated gate electrode 26 including one or more FETs. Conventional microprocessor circuits having substantially higher packing densities could be fabricated in such a manner.

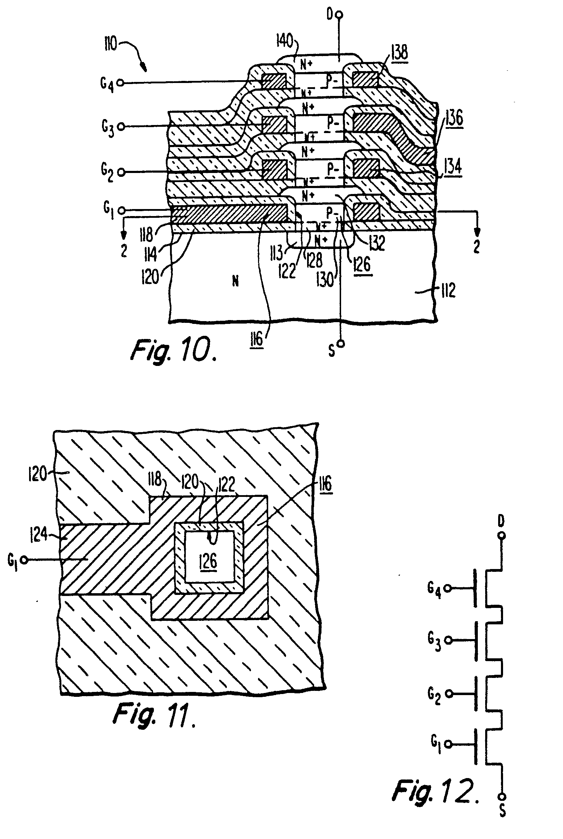

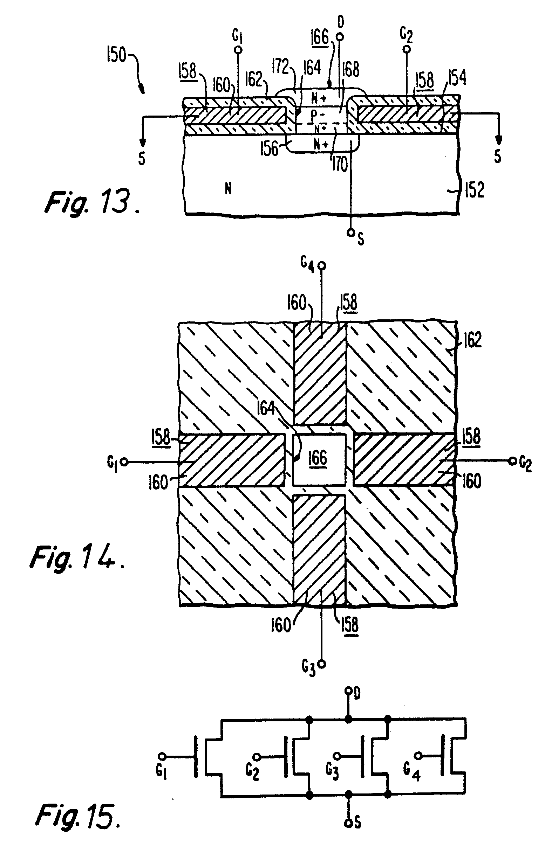

A vertically integrated IGFET device of the present invention encompasses at least two general configurations; a series-connected device 110 as illustrated in Figures 10 through 12, and a parallel-connected device 150 as illustrated in Figures 13 through 15. The series-connected device, illustrated at 110, includes a monocrystalline silicon substrate 112, of N type conductivity, having a major surface 114. An N+ type contact region 113 is disposed within the semiconductor substrate 112 at the surface 114. As will become apparent, the inclusion of this N+ contact region 113 is not essential to the invention, although its use will serve to enhance device performance. In the completed device, the contact region 113 will be connected to a source voltage, as indicated at S.

A first insulated gate 116, hereinafter first gate 116, is disposed across the surface 114 of the substrate 112, and includes an aperture 122 to the surface 114 of the substrate 112 at the location of the contact region 113. The first gate 116 comprises a gate electrode 118 of, for example, doped polycrystalline silicon, which is substantially surrounded by gate insulation 120 of, for example, silicon dioxide. The thickness of the gate electrode 118 determines the parameter of channel length, and it might have a value of approximately 100 to 5000 nm (1,000 to 50,000 Angstroms). The thickness of the gate insulating 120 may vary at different areas of the gate electrode 118. For example, underlying the gate electrode 118 it might be approximately 10 to 1000 nm (100 to 10,000 Angstroms) thick, and above the electrode 118 and within the aperture 122 it might have a thickness of approximately 10 to 100 nm (100 to 1,000 Angstroms).

As illustrated in Figure 11, the first gate 116 and the aperture 122 therein might have a substantially rectangular shape, although a variety of other configurations might equivalently be used. The first gate 116 might also conveniently include a doped polycrystalline silicon gate lead 124 to facilitate interconnection to a source of gate voltage, as indicated at $G_1$.

A monocrystallines silicon region 126 extends from the surface 114 of the substrate 112 so as to fill the aperture 112 in the first gate 116. That portion of the monocrystalline silicon region 126 which is adjacent to the contact region 113 is also of N+ type material, and forms the source region 128 of the device 110. The thickness of the source region 128 is approximately equal to the thickness of the gate insulation 120 which underlies the gate electrode 118. Overlying the source region 128 and forming a PN junction therewith is a P— type body region 130 which is preferably of lower dopant concentration than the source region 128. Overlying the body region 130 and forming a PN junction therewith is an N+ type drain region 132. Preferably, the drain region 132 also has a relatively high dopant concentration compared to the body region 130. Optimally, the body region 130 is disposed substantially opposite the gate electrode 118 portion of the first gate 116. Thus, the source/body PN junction coincides with the boundary between the gate electrode 118 and the underlying portion of the gate insulation 120, and the body/drain PN junction coincides with the boundary between the gate electrode 118 and the overlying portion of the gate insulation 120.

Second, third and fourth gates, 134, 136 and 138, respectively, connected to biases $G_2$, $G_3$ and $G_4$, respectively, are disposed in seriatum over the first gate 116. These overlying gates 134, 136 and 138 are similar in structure to the first gate 116 and are disposed such that the apertures therein are coincident with the underlying aperture 122 in the first gate 116. The monocrystalline silicon region 126 extends through the apertures in each of the overlying gates 134, 136 and 138 and is again doped so as to yield a P— type body region in opposition to the gate electrode portion of each of the gates. The uppermost portion of the monocrystalline silicon region 126 is the N+ type drain region 140 of the fourth gate 138 and is connected to a source of drain voltage, as identified at D.

It should be noted that the doping profile at the monocrystalline silicon region 126 is not restricted to the particular one shown in Figure 10. For example, an alternative embodiment comprises a monocrystalline silicon region 126 which is substantially P— type material. Such a monocrystalline silicon region 126 would still have an N+ type drain region 140 as its uppermost portion, and may include some part of the N+ type source region 128 adjacent to the N+ type contact region 113. In the structure of this alternative embodiment, it is desirable that the gate insulation between gate electrodes be relatively thin, such that when a pair of neighboring gate electrodes us appropriately biased, the corresponding pair of inversion channels is interconnected. The fringe field created by the voltage on each of the neighboring gate electrodes will serve to create a connecting inversion channel in that portion of the monocrystalline silicon region 126 which is disposed substantially opposite the gate insulation between the neighboring gate electrodes.

As previously indicated, this structure can be fabricated utilizing conventional semiconductor processing techniques which incorporate the ELO process for selective epitaxial deposition. For example, the first gate 16 can be initially formed on the surface 114 of the substrate 112 and the monocrystalline silicon region 126 can then be formed by the ELO process through the thickness of the first gate 116. Although the ELO process can be terminated when the growing monocrystalline silicon reaches the height of the gate 116, it can also be grown to a thickness greater than that of the first gate 116, as shown in Figure 10. When this occurs, the monocrystalline silicon grows laterally as well as vertically, thereby overlapping the gate 116. Such a structure may be desirable, for example, in that it provides a thicker drain region 132. Furthermore, the monocrystalline silicon region 126 can conveniently be doped simultaneously with the described epitaxial growth.

Following the formation of the monocrystalline silicon region within the first gate 116, the second gate 134 can similarly be formed and the growth of the monocrystalline silicon region 126 can similarly be continued so as to extend through the second gate 134. This sequence can then be repeated a third and a fourth time, until the four-gate structure of the illustrated embodiment is fabricated.

As an alternative processing sequence, all gates can be fabricated prior to the growth of the monocrystalline silicon region 126. The monocrystalline silicon region can then be epitaxially grown, by the ELO technique, through the apertures in all of the gates. An exemplary process sequence might be:

(1) deposit initial gate insulation on the substrate surface;

(2) deposit and dope a polycrystalline silicon gate electrode;

(3) thermally oxidize the gate electrode;

(4) repeat steps (2) and (3) the desired number of times;

(5) define an aperture by a repetitious oxide etch/polycrystalline silicon etch cycle;

(6) grow oxide within the aperture;

(7) etch the exposed initial gate insulation; and

(8) deposit and dope a monocrystalline silicon region within the aperture by the ELO technique.

A schematic representation of this structure is illustrated in Figure 12. A source to drain voltage in this structure is controlled by four, series-connected gates. Each of the gates 116, 134, 136 and 138 controls a portion of the monocrystallined silicon region 126 which is contiguous therewith. Thus, in the series-connected device 110, four vertical IGFETs are provided on a substrate area which is substantially equivalent to the area which a single IGFET would consume.

Figures 13 and 14 illustrate the structure of a parallel-connected integrated IGFET device in accordance with the present invention. As before, an N type silicon substrate 152 having a major surface 154 is provided, and an optional N+ type contact region 156 is formed at the surface 154 of the substrate 152. A plurality of gates 158, each of which again comprises a gate electrode 160 substantially surrounded by gate insulation 162, are disposed on the surface 154 of the substrate 152.

In the illustrated embodiment, four such gates 158 are provided. Each gate 158 has a finger-like configuration and is connected to a source of gate voltage, as identified at $G_1$, $G_2$, $G_3$ and $G_4$. The four gates 158 are disposed in a radial configuration on the surface 154 such that the ends of the fingers define an aperture 164 to the contact region 156. Within this aperture 164, a monocrystalline silicon region 166 extends from the surface 54 of the substrate 152. As discussed with respect to the series-connected device 110 of Figures 10 and 11, the monocrystalline silicon region 166 in the device 150 also includes a P— type body region 168 which is disposed substantially opposite the gate electrodes which surround it, and which is sandwiched between an underlying N+ type source region 170 and an overlying N+ type drain region 172. The fabrication and doping of the monocrystalline silicon region 166 can be performed in a manner similar to that described with reference to the series-connected device 110. A source of drain voltage, identified at D, is connected to the uppermost portion of the drain region 172, and a source voltage, S, is connected to the contact region 156, as shown in Figure 10.

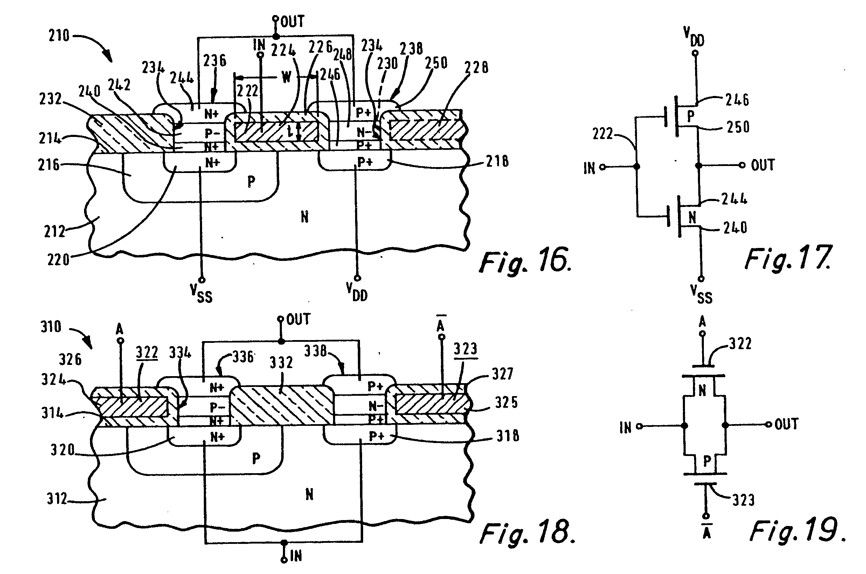

Figure 15 schematically illustrates the parallel, four-transistor structure of Figures 13 and 14. Appropriately biasing any of the gates 158 in this structure will create an inversion channel in an adjacent segment of the body region 168, and thereby permit current flow between the source and drain regions 170 and 172. Hence, as with the series-connected device 110, each of the gates can be independently biased so as to selectively create an inversion channel in that portion of the monocrystalline silicon region contiguous therewith.

As should be obvious to one skilled in the art, the scope of the present invention is not strictly limited to the specific structures described herein. For example, conductivity types of the various regions could be reversed. Similarly, the source and drain voltage sources can be reversed. Additionally, the relative conductivity between adjacent silicon regions can be manipulated. The embodiments can also be fabricated on an insulating substrate, so long as the insulating substrate includes a monocrystalline silicon portion at its surface from which the monocrystalline silicon regions 126 and 166 can be epitaxially grown.

Figure 16 illustrates the structure of a basic CMOS inverter 210 in accordance with the present invention. As shown, the inverter 210 is fabricated on a bulk, monocrystalline silicon substrate 212, although, as will be discussed subsequently, a substantially insulating substrate can alternatively be used. The substrate 212 is of N type material and has a major surface 214. Extending into the substrate 212 from the major surface 214 is a conventional P type isolation well 216 and a P+ type source/drain contact region 218 spaced therefrom. An N+ type source/drain contact region 220 extends into the substrate 212 from the surface 214 within the boundaries of the isolation well 216.

An insulated gate electrode, hereinafter referred to as a gate, is disposed on the major surface 214 as indicated at 222. The gate 222 comprises an electrode 224 which is substantially surrounded by gate insulation 226. The electrode 225 might comprise doped polycrystalline silicon, and the insulation 226 might be silicon dioxide, silicon nitride, or some combination of silicon dioxide and silicon nitride. The gate 222 can have a variety of geometric shapes. In the illustrated embodiment, it is shaped as a substantially rectangular finger. The finger has a major axis extending perpendicularly to the plane of the drawing, a width w, and a thickness t.

Alternatively, the configuration of the gate 222 can include an aperture or a plurality of apertures to the substrate surface 214. An example of such a structure is shown in phantom at 228 in Figure 16. The phantom portion 228 is continuous with the electrode 224 and is also surrounded by gate insulation so as to define an aperture at 230. As illustrated, the aperture 230 exposes the P+ type contact region 218 at the substrate surface 214. Such an apertured gate structure might alternatively or additionally expose the N+ type contact region 220 at the surface 214.

In the illustrated embodiment, field insulation 232 surrounds the finger-shaped gate 222. The field insulation 232 extends from the substrate surface 214 to a height substantially equal to that of the gate 222 and it might comprise, for example, silicon dioxide, silicon nitride, or a combination of silicon nitride and silicon dioxide. The field insulation 232 is contiguous with the gate insulation 226 so as to define an aperture 234 to each of the contact regions 218 and 220. The aperture 234, defined by the gate 222 and field insulation 232, may be identical in configuration to the previously described aperture 230 created by the alternative gate configuration.

First and second monocrystallines silicon regions, 236 and 238 respectively, extend from the N+ and P+ type source/drain contact regions 220 and 218, respectively. The monocrystalline silicon regions substantially fill the apertures 230 and 234, although they may extend to a height greater than that of the apertures 230 and 234 as shown. An N-channel vertical IGFET is formed in the first monocrystalline silicon region 236 and a P-channel vertical IGFET is formed in the second monocrystalline silicon region 238.

That part of the monocrystalline silicon region 236 which is adjacent to the N+ type contact region 220 is also of N+ type material and forms an underlying source/drain region 240 of the N-channel device. The thickness of the underlying source/drain region 240 is approximately equal to the thickness of the gate insulation 226 which underlies the electrode 224. Overlying the source/drain region 240 and forming a PN junction therewith is a P− type body region 242. Overlying the body region 242 and forming a PN junction therewith is an N+ type drain/source region 244. Optimally, the body region 242 is disposed substantially opposite the electrode 224, thus, the thickness of the body region 242 is approximately equal to t, the thickness of the electrode 224.

The second monocrystalline silicon region 238 is substantially similar in construction but, of opposite conductivity type. An underlying P+ type source/drain region 246 is adjacent to the P+ contact region 218, and is also of a thickness approximately equal to that of the gate insulation 226 which underlies the electrode 224. Overlying the P+ type source/drain region 246 and forming a PN junction therewith is an N− type body region 248, and overlying the body region 248 and forming a PN junction therewith a P+ type drain/source region 250. Again, the body region 248 is optimally disposed substantially opposite the electrode 224 portion of the gate 222, and has a thickness t.

External connections to the inverter 210 are shown schematically in Figure 16 as well as in Figure 17. High-level voltage $V_{DD}$ and low-level voltage $V_{SS}$ are connected, respectively, to the P+ type contact region 218 and N+ type contact region 220. Input to the device is made to the gate 222. A predetermined positive input voltage creates an inversion channel in the N-channel device and a predetermined negative input voltage creates an inversion channel in the P-channel device. Output from the inverter is provided from the N+ type drain/source region 244 and P+ type drain/source region 250. Although these regions can be independently externally connected to an output terminal as shown, alternative structures are equally attractive. For example, the output terminal can be connected to a metallization layer which overlies the N+ type drain/source region 244, the P+ type drain/source region 250 and the gate 222 therebetween.

Illustrated in Figure 18 is a transmission gate 310. In that there are many similarities in structure to that of the inverter 210, analogous reference numerals are used to represent analogous features (e.g. substrate 312 of the transmission gate is analogous to substrate 212 of the inverter). As with the inverter 210, the transmission gate 310 incorporates first and second monocrystalline silicon regions 336 and 338 which extend, respectively, from N+ type and P+ type source/drain contact regions 320 and 318. Disposed on the major surface 314 between the first and second monocrystalline silicon regions 336 and 338 is field insulation 332.

Rather than the single gate structure of the inverter 210, in the transmission gate 310, first and second gates 322 and 323, comprising first and second electrodes 324 and 325 surrounded by gate insulation 326 and 327 are contiguous with the first and second monocrystalline silicon regions 336 and 338. The gate insulation 326 and 327 from each of the gates is continuous with the field insulation 332 so as to define the apertures 334 in which the monocrystalline silicon regions are disposed. The first and second gates are independently biased as shown at A and Ā.

In addition to having a pair of gates which can be independently biased, the interconnection of the transmission gate 310 differs from that of the inverter 210 in that the source/drain contact regions 318 and 320 are shorted together and connected to a device input terminal. The device output terminal is connected in a similar fashion to that of the inverter 210.

Schematically, the structure is illustrated in Figure 19.

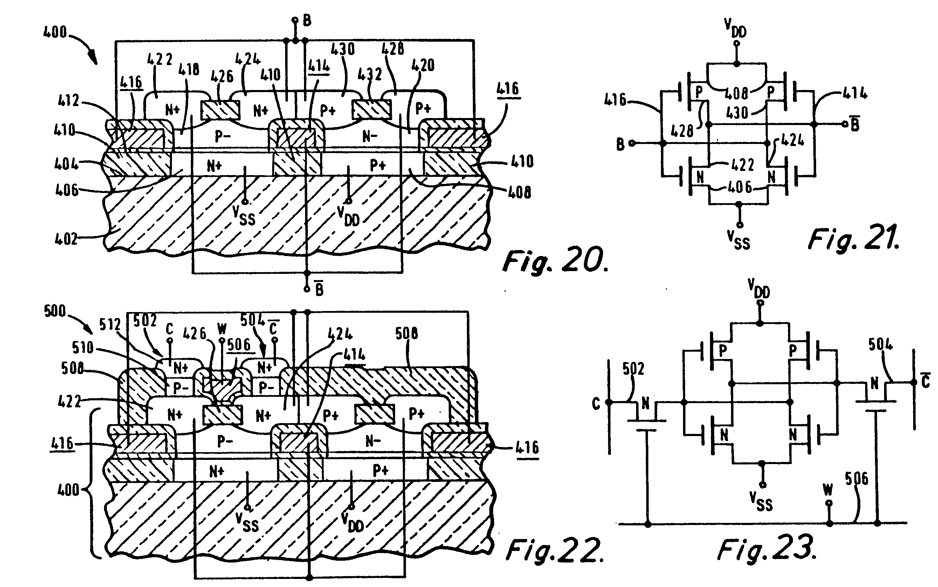

Illustrated in Figure 20 is a pair of cross-coupled inverters, hereinafter storage element 400, in accordnce with the present invention. The storage element 400 is fabricated on an insulating water 402 of a material such as sapphire. The wafer 402 has a major surface 404 on which an N+ type source/drain region 406 and a P+ type source/drain region 408 are disposed. Both of these source/drain regions are monocrystalline silicon, and they are separated from each other by an isolation oxide 410. In the preferred embodiment the isolation oxide 410 is substantially coplanar with both source/drain regions and it surrounds both source/drain regions on the surface 404. The substantially coplaner surface of source/drain regions 404 and 406 and isolation oxide 410 is identifed at 412. Thus the wafer 402, source/drain regions 404 and 406, and surface 412 of device 400 are substantially functionally equivalent to the substrate 212, source/drain contact regions 220 and 218, and surface 214 of the device 210, and can be used interchangeably in the present invention.

In an exemplary configuration for memory cell 400, the two source/drain regions 406 and 408 are arranged as parallel fingers on the surface 404. The isolation oxide 410 is disposed between the two fingers, and it surrounds the two fingers in a frame-like manner. Disposed on the isolation oxide 410 is a first gate 414 and a second gate 416. In the exemplary configuration, the first gate 414 is disposed over that portion of the isolation oxide 410 which is located between the source/drain region fingers 406 and 408. The second gate 416 is disposed on the surrounding, frame-like portion of the isolation oxide 410. As with the gate of the inverter 210, the gates 414 and 416 each comprise an electrode of particular thickness which is substantially surrounded by a gate insulation.

Extending from the N+ type source/drain region 406 is a P− type monocrystalline silicon body region 418, and extending from the P+ type source/drain region 408 is an N− type monocrystalline silicon body region 420. In addition to forming a PN junction with its respective underlying source/drain region, each of the body regions 418 and 420 is contiguous with both the first gate 414 and second gate 416. As with the previously described structures, the thickness of the body regions 418 and 420 is substantially equal to the thickness of the electrode portion of the gates 414 and 416.

First and second N+ type source/drain regions, 422 and 424 respectively, overlie the P− type body region 418 and form PN junctions therewith. These source/drain regions will hereinafter be referred to as first overlying N+ region 422 and second overlying N+ region 424. A source/drain isolation layer 426 of, for example, silicon dioxide, overlies the P− type body region 418 and serves to isolate the first overlying N+ region 422 from the second overlying N+ region 424. Thus, the first overlying N+ region 422, the P− type body region 418, and the N+ type source/drain region 406 form an N-channel FET which is controlled by the second gate 416. The second overlying N+ region 424, the P− type body region 418, and the source/drain region 406, form an N-channel FET which is controlled by the first gate 414. In an analogous fashion, two P-channel FETs are formed in conjunction with the N− type body region 420 and the P+ type source/drain region 408. First and second overlying P+ type source/drain regions 428 and 430, respectively, overlie the N− type body region 420 and form PN junctions therewith. Again, a source/drain isolation layer 432 isolates the two overlying P+ regions 428 and 430 from each other.

As illustrated, the second overlying N+ region 424 and the second overlying P+ region 430 can optionally be adjacent to one another. As indicated in Figures 20 and 21, these two regions are electrically shorted to one another as well as to the second gate 416 and are connected to an input/output terminal B. In a similar fashion, an input/output terminal B̄ is connected to the first overlying N+ region 422, the first overlying P+ region 428, and the first gate 414. Low-level

voltage $V_{SS}$ is connected to the N+ type source/drain region 406, and high-level voltage $V_{DD}$ is connected to the P+ type source/drain region 408.

Utilizing the storage element 400 as a foundation, a pair of vertical access transistors can readily be added so as to produce the memory cell 500 illustrated in Figure 22. As shown, first and second vertical N-channel access transistors, 502 and 504 respectively, are each disposed in series with one of the N-channel FETs of the storage element 400. The first and second overlying N+ regions 422 and 424 of the storage element 400 serve as source/drain regions of the first and second access transistors 502 and 504. An access transistor gate 506 is disposed on the source/drain isolation layer 426.

An overlying insulation 508 covers the overlying N+ regions 422 and 424 and is spaced from the access transistor gate 506 so as to define the geometry of the access transistors 502 and 504. Monocrystalline silicon extends from the overlying N+ regions 422 and 424 and is appropriately doped so that each has a P− type body region 510 in opposition to the electrode portion of the access transistor gate 506 and an N+ type source/drain uppermost region 512.

The uppermost N+ type source/drain region 512 of the first access transistor 502 is connected to a bit line as identified at C. The uppermost N+ type source/drain region 512 of the second access transistor 504 is electrically connected to a bit line identified at $\overline{C}$. The access transistor gate 506, which controls both access transistors 502 and 504, is connected to a word line as indicated at W. A low-level voltage supply $V_{SS}$ and high-level voltage supply $V_{DD}$ are connected to the memory cell 500 as they were connected to the storage element 400. Interconnections between the overlying N+ and P+ source/drain regions 422, 424, 428 and 430 and their respective gates 414 and 416 are the same as they were in the storage element 400. However, external connections to the first and second gates 414 and 146, as shown at B and $\overline{B}$ in Figure 20, are not made in the memory cell 500.

As previously indicated, the various devices disclosed herein can be fabricated utilizing conventional processing techniques which incorporate the ELO process for selective epitaxial deposition. An exemplary processing sequence to fabricate the inverter 210 is:

(1) Form the gate and aperture on the substrate surface.

(2) Dope the source/drain contact regions (when a bulk silicon substrate is used).

(3) Grow and dope the monocrystalline silicon regions using the ELO technique.

(4) Provide interconnections by conventional processing techniques.

In the storage element 400, the second gate as well as the first and second overlying source/drain regions can be fabricated by conventional semiconductor processing techniques. The vertical access transistors used in the memory cell 500 can also be fabricated by conventional processing and the ELO techniques.

The disclosed structures provide several significant advantages over conventional CMOS structures. The use of vertical IGFETs, wherein channel length is a function of gate electrode thickness, intrinsically provides a device with greater packing density. By vertically integrating these vertical IGFETs, as for example in the memory cell 500, an even further increase in packing density can be realized. Furthermore, the structures disclosed herein can be fabricated utilizing conventional semiconductor processing techniques, as well as self-aligned processing. It should further be recognized by one skilled in the art, that variations to the disclosed embodiments can be made without departing from the scope of the invention as enumerated in the claims.

## Claims

1. A method for fabricating a vertical IGFET device, comprising the steps of:

providing a substrate (10) having a monocrystalline semiconductor portion of a first conductivity type at a surface (12) thereof;

forming a first insulating layer (14) on said surface (12);

forming one or more gate electrodes (20) of predetermined thickness on the first insulating layer (14);

coating the electrode or electrodes with a second insulating layer (24) so as to form one or more insulated gates (26), the second insulating layer having an aperture (28) overlying a portion of said monocrystalline semiconductor portion which aperture passes through or adjacent the or each said gate electrode but is spaced therefrom;

etching the first insulating layer (14) using the insulated gate or gates (26) as an etch mask, so as to expose an area (30) of monocrystalline semiconductor material within the aperture (28) of the second insulating layer (24);

growing semiconductor material (32) epitaxially from said area (30) of monocrystallines semiconductor material so as to substantially fill the aperture (28); and

doping said epitaxial semiconductor material (32) so as to form a region (34) of second conductivity type disposed substantially opposite the or each said gate electrode (20), and a region (36) of first conductivity type overlying said second-conductivity-type region (34).

2. A method according to Claim 1 in which there is an aperture (22) through a said gate electrode (20), the electrode aperture overlying a portion of said monocrystalline semiconductor portion, the second insulating layer (24) and the aperture (28) therethrough passing through the aperture (22) in the electrode (20).

3. A method in accordance with Claim 2, wherein said gate electrode (20) is formed by the steps of:

forming a layer of doped polycrystalline silicon; and

photolithographically defining said aperture (22) in the electrode (20).

4. A method in accordance with Claim 2, wherein said gate electrode (20) is formed by the steps of:

forming a layer of doped polycrystalline silicon:

forming a supplementary insulating layer (42) on the surface of said polycrystalline silicon; and

forming said electrode aperture (22) through said supplementary insulating layer and said polycrystalline silicone layer.

5. A method in accordance with Claim 2, wherein said second insulating layer (24) is silicon dioxide and further comprising:

providing a doped polycrystalline silicon gate electrode; and

forming said second insulating layer by thermal oxidation so as to yield a predetermined thickness of said second insulating layer within said aperture in said electrode.

6. A method in accordance with any of Claims 1 to 5, wherein said first insulating layer (14) comprises:

a lower layer (16) disposed on said substrate surface; and

an upper layer (18) disposed on said lower layer.

7. A method in accordance with Claim 6, wherein said lower layer is silicon dioxide and said upper layer is silicon nitride.

8. A method in accordance with Claim 1, further comprising:

between said etching and said growing steps, doping said area of monocrystalline semiconductor material exposed within said aperture.

9. A method in accordance with Claim 8, comprising ion implanting a conductivity modifier of the first conductivity type so as to achieve said doping.

10. A method in accordance with any of the preceding claims, further comprising doping said epitaxial semiconductor material simultaneous with the growing thereof.

11. A method in accordance with any of the preceding claims, wherein said substrate comprises an insulating wafer having a layer disposed on a surface thereof, said layer comprising a monocrystalline semiconductor island surrounded by insulating material.

12. A method in accordance with Claim 11, wherein said substrate is formed by the steps of:

forming a monocrystalline silicon layer on an insulating wafer;

masking a portion of said silicon layer;

oxidizing the unmasked portion of said silicon layer; and

stripping said mask.

13. A vertical IGFET device, comprising:

a substrate (10) having a monocrystalline semiconductor portion of a first conductivity type at a surface (12) thereof; and

an insulated gate (26) disposed on the surface (12) of said substrate (10);

said insulated gate (26) including an aperture (28) to an area (30) of the monocrystalline semiconductor portion; and

an epitaxial semiconductor region (32) extends from the surface (12) of said substrate (10) within said aperture (28), said epitaxial region (32) having a portion (34) of second conductivity type within said aperture (28), and a portion (36) of first conductivity type overlying the second conductivity type portion (34), characterized in that:

the insulation of said insulated gate (26) contacts said surface (12) of said substrate; and

said epitaxial semiconductor region (32) extends to a height substantially equal to that of the insulated gate (26).

14. A device in accordance with Claim 13, wherein said substrate (10) comprises monocrystalline silicon; and

said insulated gate (26) comprises a layer of doped, polycrystalline silicon having a plurality of apertures (28) therein, each aperture (28) including an epitaxial region (32) extending from the surface (12) of said substrate (10).

15. A device in accordance with Claim 14, wherein said substrate (10) comprises a plurality of said monocrystalline semiconductor portions at a surface thereof and wherein said insulated gate (26) comprises a layer of doped, polycrystalline silicon having a plurality of apertures (28) therein, each aperture (28) exposing a monocrystalline semiconductor area (30) and including an epitaxial region (32) extending from the surface (12) of said substrate (10).

**Patentansprüche**

1. Verfahren zum Herstellen eines vertikalen Feldeffektransistors mit isoliertem Gate, umfassend die Stufen:

Schaffen eines Substrates (10) mit einem monokristallinem Halbleiterabschnitt eines ersten Leitfähigkeitstyps an einer Oberfläche (12) davon,

Bilden einer ersten isolierenden Schicht (14) auf der genannten Oberfläche (12),

Bilden einer oder mehrerer Gatelektroden (20) vorbestimmter Dicke auf der ersten isolierenden Schicht (14),

Überziehen der Elektrode oder Elektroden mit einer zweiten isolierenden Schicht (24), um ein oder mehrere isolierte Gates (26) zu schaffen, wobei die zweite isolierende Schicht eine Öffnung (28) aufweist, die über einem Teil des monokristallinen Halbleiterabschnittes liegt und durch die oder jede Gatelektrode oder benachbart dazu verläuft, jedoch im Abstand davon,

Ätzen des ersten isolierenden Schicht (14) unter Verwendung des oder der isolierten Gates (26) als Ätzmaske, um einen Bereich (30) aus einkristallinem Halbleitermaterial innerhalb der Öffnung (28) der zweiten isolierenden Schicht (24) freizulegen,

epitaxiales Aufwachsen von Halbleitermaterial (32) von dem genannten Bereich (30) aus einkristallinem Halbleitermaterial aus, um die Öffnung (28) im wesentlichen zu füllen und

Dotieren des epitaxialen Halbleitermaterials (32), um einen Bereich (34) eines zweiten Leitfähigkeitstyps, der im wesentlichen gegenüber der oder jeder Gateelektroden (20) angeordnet ist und einen Bereich (36) des ersten Leitfähigkeitstyps zu bilden, der über dem Bereich (34) der zweiten Leitfähigkeitstups liegt.

2. Verfahren nach Anspruch 1, bei dem es eine Öffnung (22) durch die Gateelektrdoe (20) gibt, wobei die Elektrodenöffnung über einem Teil des einkristallinen Halbleiterabschnittes liegt und die zweite isolierende Schicht (24) und die durch sie hindurchgehende Öffnung (28) durch die Öffnung (22) in der Elektrode (20) hindurchgehen.

3. Verfahren nach Anspruch 2, worin die Gateelektrode (20) durch die folgenden Stufen gebildet wird:

Bilden einer Schicht aus dotiertem polykristallinem Silizium, und

fotolithografisches Begrenzen der Öffnung (22) in der Elektrode (20).

4. Verfahren nach Anspruch 2, worin die Gateelektrode (20) durch die folgenden Stufen gebildet wird:

Bilden einer Schicht aus dotiertem polykristallinem Silizium,

Bilden einer zusätzlichen isolierenden Schicht (42) auf der Oberfläche des polykristallinem Siliziums und

Bilden der Elektrodenöffnung (22) durch die zusätzliche isolierende Schicht und die Schicht aus polykristallinem Silizium.

5. Verfahren gemäß Anspruch 2, worin die zweite isolierende Schicht (24) Siliziumdioxid ist und das Verfahren weiter umfaßt:

das Schaffen einer Gateelektrode aus dotiertem polykristallinem Silizium und

Bilden der zweiten isolierenden Schicht durch thermische Oxidation, um der zweiten isolierenden Schicht innerhalb der Öffnung in der Elektrode eine vorbestimmte Dicke zu geben.

6. Verfahren nach irgendeinem der Ansprüche 1 bis 5, vorin die erste isolierende Schicht (14) umfaßt:

eine untere Sc/ht (16), die auf der Substratoberfläche angeordnet ist,

eine obere Schicht (18) die auf der unteren Schicht angeordnet ist.

7. Verfahren nach Anspruch 6, worin die untere Schicht Siliziumdioxid und die obere Schicht Siliziumnitrid ist.

8. Verfahren nach Anspruch 1, weiter umfassend:

Dotieren des Bereiches einkristallinen Halbleitermaterials, das innerhalb der Öffnung freigelegt ist, zwischen den Stufen des Ätzens und Aufwachsens.

9. Verfahren nach Anspruch 8, umfassend das Ionenimplantieren eines die Leitfähigkeit des ersten Leitfähigkeitstyps modifizierenden Materials, um das genannte Dotieren zu bewerkstelligen.

10. Verfahren nach irgendeinem der vorgehenden Ansprüche, weiter umfassend das Dotieren des epitaxialen Halbleitermaterials gleichzeitig mit seinem Aufwachsen.

11. Verfahren nach irgendeinem der vorhergehenden Ansprüche, worin das Substrat einen isolierenden Wafer umfaßt, der auf einer Oberfläche eine Schicht aufweist, die eine Insel aus einkristallinem Halbleiter, umgeben von isolierendem Material, umfaßt.

12. Verfahren nach Anspruch 11, worin das Substrat durch die folgenden Stufen gebildet wird:

Bilden einer einkristallinen Siliziumschicht auf einer isolierenden Scheibe,

Maskieren eines Abschnittes der Siliziumschicht,

Oxidieren des nicht-maskierten Abschittes der Siliziumschicht und

Abziehen der Maske.

13. Vertikaler Feldeffekttransistor mit isoliertem Gate, umfassend:

ein Substrat (10) mit einem einkristallinem Halbleiterabschnitt eines ersten Leitfähigkeitstyps an einer Oberfläche (12) davon und

ein isoliertes Gate (26), das auf der Oberfläche (12) des Substrates (10) angeordnet ist,

wobei das isolierte Gate (26) eine Öffnung (28) zu einem Bereich (30) des einkristallinen Halbleiterabschnittes einschließt und

sich ein epitaxialer Halbleiterbereich (32) von der Oberfläche (12) des Substrates (10) innerhalb der Öffnung (28) aus erstreckt, wobei der epitaxiale Bereich (32) einen Abschnitt (34) eines zweiten Leitfähigkeitstyqs innerhalb der Öffnung (28) und einen Abschnitt (36) eines ersten Leitfähigkeitstyps aufweist, der über dem Abschnitt (34) des zweiten Leitfähigkeitstyps liegt,

dadurch gekennzeichnet, daß die Isolation des isolierten Gates (26) die Oberfläche (12) des Substrates berührt und

der epitaxiale Halbleiterbereich (32) sich bis zu einer Höhe erstreckt, die im wesentlichen gleich der des isolierten Gates (26) ist.

14. Element nach Anspruch 13, worin das Substrat (10) einkristallines Silizium und das isolierte Gate (26) eine Schicht aus dotiertem polykristallinem Silizium umfaßt, das mehrere Öffnungen (28) enthält, wobei jede Öffnung (28) einen epitaxialen Bereich (32) einschließt, der sich von der Oberfläche (12) des Substrates (10) aus erstreckt.

15. Element nach Anspruch 14, worin das Substrat (10) mehrere Abschnitte aus einkristallinem Halbleiter an einer Oberfläche davon umfaßt und das isolierte Gate (26) eine Schicht aus dotiertem polykristallinem Silizium umfaßt, die mehrere Löcher (28) enthält, wobei jede Öffnung (28) einen Bereich (30) einkristallinen Siliziums freilegt und einen Epitaxialbereich (32) einschließt, der sich von der Oberfläche (12) des Substrates (10) aus erstreckt.

**Revendications**

1. Procédé pour la fabrication d'un IGFET vertical, comprenant les étapes consistant à:

fournir un substrat (10) ayant une partie en semiconducteur monocristallin d'un premier type de conductivité à une surface (12) de celui-ci;

former une première couche isolante (14) sur la surface (12);

former une ou plusieurs électrodes de grille (20) d'une épaisseur prédéterminée sur la première couche isolante (14);

revêtir l'électrode ou les électrodes avec une seconde couche isolante (24) de manière à former une ou plusieurs grilles isolées (26), la seconde couche isolante comportant une ouverture (28) qui recouverte une partie de la portion en semi-conducteur monocristallin, ouverture qui traverse l'électrode de grille où chaque électrode de grille, ou est contigüe à celle-ci, mais en est espacée;

graver la première couche isolante (14) en utilisant la ou les grilles isolées (26) comme masque de gravure, de manière à exposer une surface (30) du matériau semiconducteur monocristallin à l'intérieur de l'ouverture (28) de la seconde couche isolante (24);

faire croître de manière épitaxiale un matériau semi-conducteur (32) à partir de ladite surface (30) en matériau semi-conducteur monocristallin de manière à remplir sensiblement l'ouverture (28);

doper le matériau semi-conducteur épitaxial (32) de manière à former une région (34) d'un second type de conductivité disposée en étant sensiblement opposée à l'électrode de grille ou à chaque électrode de grille (20), et une région (36) du premier type de conductivité recouvrant la région (34) du second type de conductivité.

2. Procédé selon la revendication 1, dans lequel il y a une ouverture (22) à travers ladite électrode de grille (20), l'ouverture de l'électrode recouvrant une partie de la portion en semi-conducteur monocristallin, la seconde couche isolante (24) et l'ouverture (28) traversant l'ouverture (22) ménagée dans l'électrode (20).

3. Procédé selon la revendication 2, dans lequel l'électrode de grille (20) est obtenue en suivant les étapes consistant à:

former une couche de silicium polycristallin dopé; et

définir photolithographiquement l'ouverture (22) dans l'électrode (20).

4. Procédé selon la revendication 2, dans lequel l'électrode de grille (20) est obtenue en suivant les étapes consistant à:

former une couche de silicium polycristallin dopé;

former une couche isolante supplémentaire (42) sur la surface du silicium polycristallin; et former l'ouverture (24) de l'électrode à travers la couche isolante supplémentaire et la couche de silicium polycristallin.

5. Procédé selon la revendication 2, dans lequel la seconde couche isolante (24) est en dioxyde de silicium et en ce qu'il comprend en outre les étapes consistant à:

fournir une électrode de grille en silicium polycristallin dopé; et

former la seconde couche isolante par oxydation thermique de manière à obtenir une épaisseur prédéterminée de la seconde couche isolante à l'intérieur de l'ouverture ménagée dans l'électrode.

6. Procédé selon l'une quelconque des revendications 1 à 5, dans lequel la première couche isolante (14) comprend:

une couche inférieure (16) disposée sur la surface du substrat; et

une couche supérieur (18) disposée sur la couche inférieure.

7. Procédé selon la revendication 6, dans lequel la couche inférieure est en dioxyde de silicium et la couche supérieure est du nitrure de silicium.

8. Procédé selon la revendication 1, caractérisé en ce qu'il comprend en outre:

entre les étapes de gravure et de croissance, l'étape consistant à doper la surface du matériau en semi-conducteur monocristallin exposé à l'intérieur de l'ouverture.

9. Procédé selon la revendication 8, comprenant l'étape d'implantation ionique d'un modificateur de conductivité du premier type de conductivité de manière à obtenir ledit dopage.

10. Procédé selon l'une quelconque des revendications précédentes, comprenant en outre l'étape de dopage du matériau semi-conducteur épitaxial simultanément à sa croissance.

11. Procédé selon l'une quelconque des revendications précédentes, dans lequel le substrat comprend une tranche isolante ayant une couche disposée sur l'une de ses surfaces, la couche comprenant une île en semi-conducteur monocristallin entourée par du matériau isolant.

12. Procédé selon la revendication 11, dans lequel le substrat est formé en suivant les étapes consistant à:

former une couche de silicium monocristallin sur une tranche isolante;

masquer une partie de la couche de silicium;

oyder la partie non masquée de la couche de silicium; et

étacher le masque.

13. IGFET vertical, comprenant:

un substrat (10) ayant une portion en semi-conducteur monocristallin d'un premier type de conductivité à l'une de ses surfaces (12); et

une grille isolée (26) disposée sur la surface (12) du substrat (10),

la grille isolée (26) comprenant une ouverture (28) jusqu'à une surface (30) de la portion en semi-conducteur monocristallin, et

une région épitaxiale en semi-conducteur (32) s'étend à partir de la surface (12) du substrat (10) à l'intérieur de l'ouverture (28), la région épitaxiale (32) ayant une partie (34) d'un second type de conductivité à l'intérieur de l'ouverture (28), une partie (36) d'un premier type de conductivité recouvrant la partie (34) du second type de conductivité, caractérisé en ce que:

l'isolement de la grille isolée (26) est en contact avec la surface (12) du substrat; et

la région (32) épitaxiale en semi-conducteur s'étend jusqu'à une hauteur sensiblement égale à celle de la grille isolée (26).

14. Dispositif selon la revendication 13, dans lequel le substrat (10) comprend du silicium monocristallin, et

la grille isolée (26) comporte une couche de silicium polycristallin dopé, ayant une multitude d'ouvertures (28), chaque ouverture (28) comprenant une région épitaxiale (32) qui s'étend à partir de la surface (12) du substrat (10).

15. Dispositif selon la revendication 14, dans lequel le substrat (10) comprend une multitude de portions de semi-conducteur monocristallin à l'une de ses surfaces et dans lequel la grille isolée (26) comprend une couche de silicium polycristallin dopé, ayant une multitude d'ouvertures (28); chaque ouverture (28) exposant une zone (30) de semi-conducteur monocristallin et comportant une région épitaxiale (32) qui s'étend à partir de la surface (12) du substrat (10).

Fig. 1.

Fig. 5.

Fig. 2.

Fig. 6.

Fig. 3.

Fig. 7.

Fig. 4.

Fig. 8.

Fig. 9.

**Fig. 10.**

**Fig. 11.**

**Fig. 12.**

Fig. 13.

Fig. 14.

Fig. 15.

Fig.16.

Fig.17.

Fig.18.

Fig.19.

Fig. 20.

Fig. 21.

Fig. 22.

Fig. 23.

EP 0 098 111 B1